Europäisches Patentamt

European Patent Office

Office européen des brevets

(19)

(11) **EP 1 589 346 A1**

(12) **EUROPÄISCHE PATENTANMELDUNG**

(43) Veröffentlichungstag:
**26.10.2005 Patentblatt 2005/43**

(51) Int Cl.⁷: **G01R 31/36**

(21) Anmeldenummer: **05103015.3**

(22) Anmeldetag: **15.04.2005**

(84) Benannte Vertragsstaaten:
**AT BE BG CH CY CZ DE DK EE ES FI FR GB GR HU IE IS IT LI LT LU MC NL PL PT RO SE SI SK TR**
Benannte Erstreckungsstaaten:
**AL BA HR LV MK YU**

(30) Priorität: **23.04.2004 DE 102004020405**
**06.04.2005 DE 102005015727**

(71) Anmelder:
• **ROBERT BOSCH GMBH**
**70442 Stuttgart (DE)**
Benannte Vertragsstaaten:
**DE FR GB IT SE**
• **VB Autobatterie GmbH**
**30419 Hannover (DE)**
Benannte Vertragsstaaten:
**DE FR GB IT SE**

(72) Erfinder:
• **Rauchfuss, Lutz**
**71701, Schwieberdingen (DE)**
• **Ehret, Christine**
**89275, Thalfingen (DE)**
• **Laig-Hoerstebrock, Helmut**
**60320, Frankfurt (DE)**

(54) **Verfahren zur Ermittlung der Ruhespannung einer Speicherbatterie**

(57) Bei einem Verfahren zur Ermittlung der Ruhespannung ($U_{00}$) einer Speicherbatterie erfolgt ein Bestimmen von Betriebsparametern der Speicherbatterie in der Ruhephase und ein Bestimmen der Ruhespannung ($U_{00}$) mit jeweils einer in Abhängigkeit von den Betriebsparametern ausgewählten Ruhespannungsermittlungsroutine.

Fig. 1

**Beschreibung**

Die Erfindung betrifft ein Verfahren zur Ermittlung der Ruhespannung einer Speicherbatterie.

Für einige Funktionen zur Ermittlung und Vorhersage des Zustands einer Speicherbatterie, wie beispielsweise die Prädiktion der Leistungsfähigkeit, die Verlustkapazität, die Säureschichtung usw. kann als Eingangsgröße die Ruhespannung bzw. der Ladezustandswert SOC benötigt werden. Der Ladezustandswert SOC kann durch eine Lade-/Entlade-Strombilanzierung bestimmt werden. In längeren Betriebsphasen driftet der solchermaßen ermittelte Ladezustandswert SOC von dem tatsächlichen Ladezustand weg. Deshalb wird ab und zu eine Rekalibrierung benötigt. Diese Rekalibrierung kann bei voll geladener Batterie oder in ausreichend langen Ruhephasen anhand der sich einstellenden Ruhespannung vorgenommen werden. Ein Problem tritt dadurch auf, dass eine Fahrzeugbatterie nie voll geladen wird und auch meistens keine ausreichend langen Ruhephasen (bei tiefen Temperaturen bis zu 48 Stunden) vorliegen, so dass die gemessene Batteriespannung nicht der Ruhespannung entspricht.

In der DE 101 28 033 A1 ist ein Verfahren zur Vorhersage der äquilibrierten Ruhespannung eines elektrochemischen Energiespeichers beschrieben, bei dem durch Extrapolation bereits zu einem frühen Zeitpunkt auf die sich einstellende Ruhespannung geschlossen werden kann. Hierzu werden Ruhephasen von 4 Stunden und mehr benötigt. Nachteilig sind Ruheströme von bis ca. -50 mA erlaubt. Zu einem ersten frühen Zeitpunkt von etwa 2 Stunden wird die unbelastete Spannung gemessen und von diesem Wert der omsche Anteil abgezogen. Hierdurch kann ein erster Ladezustandswert SOC bestimmt werden. Da in den Ruhephasen auch ein Ruhestrom fließt, wird insgesamt auch die Polarisation berücksichtigt.

Aufgabe der Erfindung ist es ein verbessertes Verfahren zur Ermittlung der Ruhespannung einer Speicherbatterie zu schaffen, das in verschiedenen Betriebssituationen (Ruhestrom, Ruhezeiten) eine noch genauere Ermittlung der Ruhespannung ermöglicht.

Die Aufgabe wird mit dem gattungsgemäßen Verfahren erfindungsgemäß gelöst durch Bestimmen von Betriebsparametern der Speicherbatterie in der Ruhephase und Bestimmen der Ruhespannung mit jeweils einer in Abhängigkeit von den Betriebsparametern ausgewählten Ruhespannungsermittlungsroutine.

Es wird somit vorgeschlagen, in Abhängigkeit von den Betriebsparametern, d. h. der jeweils vorliegenden Betriebssituation, ein geeignetes Verfahren zur Ruhespannungsermittlung zu nutzen. Beispielsweise wird je nach Ruhestrom und/oder Ruhezeit eine optimierte Routine zur Ruhespannungsermittlung genutzt, wobei diverse Korrekturen beispielsweise für den Fall hoher Ruheströme eingeführt werden könne.

Vorteilhaft ist es, wenn die aktuelle Ruhezeit und der Ruhestrom der Batterie als Betriebsparameter bestimmt und die Ruhespannungsermittlungsroutine in Abhängigkeit von diesen Betriebsparametern ausgewählt wird.

Besonders vorteilhaft ist es, wenn zunächst der Ladezustand der Deltakapazität der Speicherbatterie als Betriebsparameter bestimmt wird. Die Ladung der Deltakapazität kann beispielsweise nach der Formel $Q(k)=C_\delta * U_{Pol}(k)/3600Ah/s$ ermittelt werden. Dann kann bei Entladung der Deltakapazität in Abhängigkeit von der Ruhezeit eine Auswahl der Ruhespannungsermittlungsroutine erfolgen. Wenn die Deltakapazität nicht entladen ist, kann in Abhängigkeit von dem Ruhestrom eine Auswahl der geeigneten Ruhespannungsermittlungsroutine erfolgen.

Vorzugsweise wird die Ruhespannung mit einer die Polarisation der Speicherbatterie berücksichtigenden Ruhespannungsermittlungsroutine bestimmt, wenn die aktuelle Ruhezeit größer als 2 Stunden und die Deltakapazität entladen ist. Hierzu kann die Ruhespannung beispielsweise nach der Beziehung

$$U_{00}=U_{Batt} * R_i * I_{Batt} * U_{pol,2}$$

mit der Batteriespannung $U_{Batt}$, dem Innenwiderstand $R_i$ der Batterie, dem Batteriestrom $I_{Batt}$ und der Polarisationsspannung $U_{pol,2}$ bestimmt werden.

Die Polarisationsspannung $U_{pol,2}$ kann nach der Formel

$$U_{pol,2}=(1{,}271 * I_{Batt}+2{,}281 * I_{Batt}^2+ 1{,}293 * I_{Batt}^3) * (1-0{,}0116 * T_{Batt}[°C])$$

mit der Batterietemperatur $T_{Batt}[°C]$ bestimmt werden.

Für den Fall, dass die Deltakapazität entladen ist und die aktuelle Ruhezeit weniger als 2 Stunden beträgt, sowie für den Fall, dass die Deltakapazität nicht entladen ist und der absolute Batteriestrom mehr als 200 mA beträgt (-500 mA < $I_{Batt}$ < -200 mA) wird die Ruhespannung vorzugsweise mit einer den auf die Säurekapazität der Speicherbatterie bezogenen Ladezustand berücksichtigenden Ruhespannungsermittlungsroutine bestimmt. Dies kann beispielsweise mit der Beziehung

$$U_{00}=(SOC_0(Q_0)-q/Q_0)*(U_{00,max}-U_{00,min})+U_{00,min}.$$

mit einer für den Speicherbatterietyp definierten minimalen Ruhespannung $U_{00,min}$ und maximalen Ruhespannung $U_{00,max}$, der Ladebilanz q und der Säurekapazität $Q_0$ erfolgen. Diese Ruhespannungsermittlung führt den Ladezustandswert SOC über eine Stromintegration nach, d. h. vorzugsweise wird die Ladebilanz Q durch Integration des Batteriestroms ermittelt.

Für den Fall, dass die Deltakapazität nicht entladen ist und der Entlade-Batteriestrom einen Wert von -200 mA nicht überschreitet (-200 mA < $I_{Batt}$ < 0 mA), wird die Ruhespannung vorzugsweise durch Extrapolation von zu verschiedenen Zeitpunkten t in der Ruhephase ermittelten Ruhespannungswerten bestimmt. Dabei wird vorzugsweise, wenn die Ruhezeit größer als 4 Stunden und der Entlade-Batteriestrom größer als -50 mA ist (-200 mA < $I_{Batt}$ < -50 mA), eine Extrapolation der Ruhespannung in Abhängigkeit von einer defmierten Polarisationsspannung durchgeführt. Die Polarisationsspannung wird dabei vorzugsweise von der durch Extrapolation ermittelten Ruhespannung subtrahiert.

Für den Fall, dass der Entlade-Batteriestrom im Bereich von 0 bis -50 mA liegt und die Deltakapazität nicht entladen ist, wird die Ruhespannung beispielsweise mit dem in der DE 101 28 033 A1 beschriebenen Extrapolationsverfahren ohne weitere Korrektur der Polarisation bestimmt.

Weiterhin ist es vorteilhaft, wenn die Ermittlung der Ruhespannung grundsätzlich in Abhängigkeit von der Batterietemperatur durchgeführt wird.

Die Erfindung wird nachfolgend anhand der beigefügten Zeichnung näher erläutert. Es zeigt:

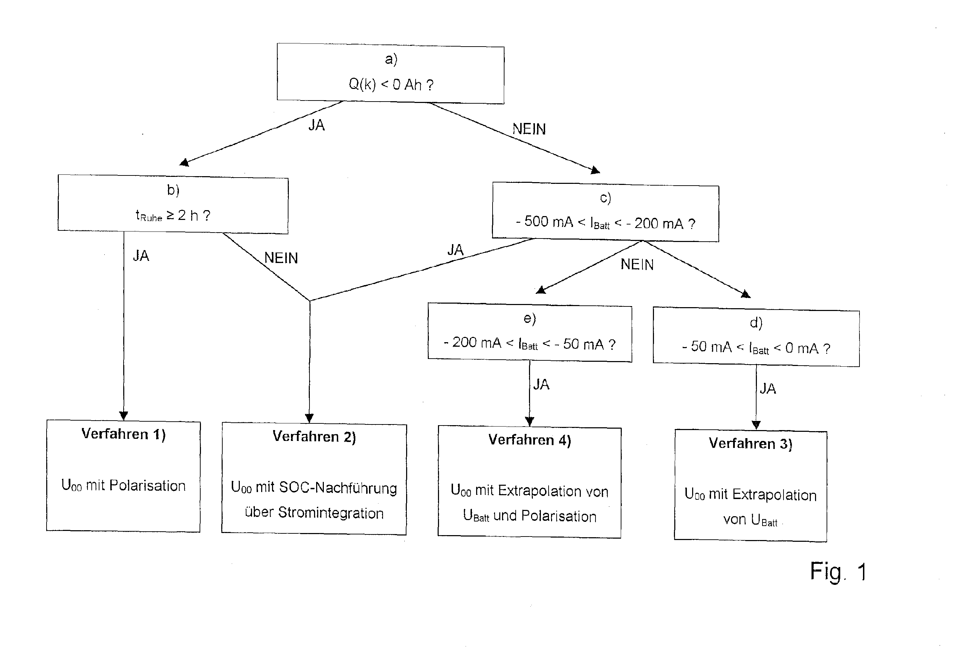

Figur 1 -einen Entscheidungsbaum zur Auswahl von Ruhespannungsermittlungsroutinen gemäß der vorliegenden Erfindung.

Die Figur 1 lässt einen Entscheidungsbaum zur Auswahl von Ruhespannungsermittlungsroutinen gemäß der vorliegenden Erfindung erkennen.

In einem ersten Schritt a) wird untersucht, ob die Deltakapazität $C_\delta$ geladen oder entladen ist. Hierzu wird die Ladung Q(k) der Deltakapazität $C_\delta$ beispielsweise nach der Formel

$$Q(k)=C_\delta*U_{Pol,1}\ [k]/3600[Ah/s]$$

berechnet. Die Deltakapazität $C_\delta$ beträgt für Bleiakkumulatoren typischerweise 4000 F.

Die Polarisationsspannung $U_{Pol,1}$ berechnet sich hierbei durch

$$U_{pol,1}[k]=U_{Batt}[k]-U_{00}[k-1]-R_i[k-1]*I_{Batt}[k].$$

Dabei ist $U_{Batt}[k]$ die zum Messzeitpunkt k gemessene Batterieklemmenspannung. $U_{00}[k-1]$ ist die aus der vorangegangenen Ruhephase oder Betriebsphase ermittelte Ruhespannung $U_{00}$. $R_i[k-1]$ ist der aus der vorangegangenen Ruhephase oder Betriebsphase ermittelte Innenwiderstand der Batterie und $I_{Batt}[k]$ ist der beispielsweise an den Klemmen gemessene Batteriestrom.

Für den Fall, dass im Schritt a) festgestellt wird, dass die Deltakapazität $C_\delta$ entladen ist, d. h. wenn Q[k]<0Ah ist, wird die Ruhezeit $t_{Ruhe}$, d. h. die Dauer der aktuellen Ruhephase ausgewertet und für den Fall, dass die Ruhezeit $t_{Ruhe}$ größer oder gleich 2 Stunden ist, die Ruhespannung $U_{00}$ unter Berücksichtigung der Polarisationsspannung $U_{pol,2}$ nach der Beziehung

$$U_{00}=U_{Batt}-R_i*I_{Batt}-U_{Pol,2}$$

bestimmt (Verfahren 1), wobei $U_{Batt}$ die Batterieklemmenspannung, $I_{Batt}$ der Batterieklemmenstrom und $R_i$ der Innenwiderstand ist. Die Polarisationsspannung $U_{pol,2}$ berechnet sich für Bleiakkumulatoren beispielsweise nach der Formel

$$U_{Pol,2}=(1,271*I_{Batt}+2,281*I_{Batt}^2+1,293*I_{Batt}^3)*(1-0,0116*T_{Batt}[°C]).$$

Der Entladestrom $I_{Batt}$ wird hierbei mit negativem Vorzeichen in die Gleichung eingesetzt.

Wird im Schritt b) festgestellt, dass die Ruhezeit kleiner als 2 Stunden ist, erfolgt eine Bestimmung der Ru-

hespannung $U_{00}$ durch Nachführung des Ladezustandswertes SOC über eine Stromintegration (Verfahren 2). Hierzu wird beispielsweise der auf die Säurekapazität $Q_0$ bezogene Ladezustand SOC ($Q_0$) im Betriebsmodus über den aus der Ruhespannung $U_{00}$ ermittelten Anfangsladezustand $SOC_0(U_{00}(T_{Batt}=25°C))$ und die Ladebilanz q nach der Formel

$$SOC(Q_0)=SOC_0(U_{00}(T_{Batt}=25°C))+q/Q_0$$

berechnet. Der Anfangsladezustand $SOC_0(U_{00}(T_{Batt}=25°C))$ wird beispielsweise nach der Beziehung

$$SOC_0(U_{00}(T_{Batt}=25°C))=(U_{00}(T_{Batt}=25°C)-U_{00,min}(T_{Batt}=25°C))/(U_{00,max}(T_{Batt}=25°C)-$$

$$U_{00,min}(T_{Batt}=25°C))$$

bestimmt. Für den Fall von leeren (AGM-)Batterien mit einer Anzahl von 6 Zellen bei 25°C beträgt die minimale Ruhespannung

$$U_{00,min}(T_{Batt}=25°C)=6*1,90 \text{ Volt}=11,40 \text{ Volt.}$$

Die maximale Ruhespannung $U_{00, max}$ der vollen (AGM-)Batterie mit 6 Zellen bei 25°C beträgt

$$U_{00,max}(T_{Batt}=25°C)=6*2,1416 \text{ Volt}=12,85 \text{ Volt.}$$

Die Ruhespannung $U_{00}$ berechnet sich dann zu:

$$U_{00} = SOC (Q_0) * (U_{00,max} - U_{00,min}) + U_{00,min}.$$

Die Bestimmung der Ruhespannung $U_{00}$ mit Hilfe der Nachführung des Ladezustandswerts SOC über die Stromintegration (Verfahren 2) erfolgt auch, wenn im Schritt a) festgestellt wird, dass die Deltakapazität $C_\delta$ nicht entladen ist und der Entlade-Batteriestrom $I_{Batt}$ im Bereich von -200 bis -500 mA liegt.

Für den Fall, dass im Schritt a) festgestellt wird, dass die Deltakapazität $C_\delta$ nicht entladen ist (Q[k]>0 Ah) und der Entlade-Batteriestrom $I_{Batt}$ kleiner als -200 mA ($I_{Batt}$> -200 mA) ist (Schritt c)), erfolgt die Ermittlung der Ruhespannung durch Extrapolation der Batterieklemmenspannung $U_{Batt}$ (Verfahren 3 und 4). Dabei wird der Einfluss des Ruhestroms $I_{Batt}$ auf die Batteriespannung $U_{Batt}$ durch eine Korrekturfunktion berücksichtigt. So wird mit Hilfe dieser Korrektur aus der gemessenen Batteriespannung $U_{Batt}$ und dem gemessenen Ruhestrom $I_{Batt}$ die korrespondierende Ruhespannung $U_{00}$ der Speicherbatterie (ruhestromfrei) berechnet.

Würde die Batterie unmittelbar vor der Ruhephase geladen, kann der Einschwingvorgang der Batteriespannung $U_{Batt}$ auf die stationäre Ruhespannung $U_{00}$ abhängig vom Ladezustand SOC und der Temperatur $T_{Batt}$ der Batterie unter Umständen einige Stunden bis Tage dauern. In diesem Falle wird die Ruhespannung $U_{00}$ durch Extrapolation der während der Ruhephase in bestimmten Zeitabständen gemessenen Batteriespannung $U_{Batt}$ berechnet. Für Ruheströme bis -50mA ist ein solches Verfahren (Verfahren 3) in der oben genannten DE 101 28 033 A1 ausführlich beschrieben.

Die Extrapolationsformel geht von fest vorgegebenen Messzeitpunkten $t_{Ruhe}$, I=1..5=2 Stunden, 4 Stunden, 8 Stunden, 16 Stunden und 24 Stunden aus. Zu Beginn der Ruhephase ist $t_{Ruhe}$=0 Stunden. Die Ruhespannung $U_{00}$ wird jeweils aus der aktuell gemessenen Batteriespannung $U_{Batt}(t_{Ruhe,i})$ und der zum vorhergehenden Messzeitpunkt gemessenen Batteriespannung $U_{Batt}(t_{Ruhe,i-1})$ sowie der aktuellen Batterietemperatur $T_{Batt}(t_{Ruhe,i})$ ermittelt. Die Batterietemperatur $T_{Batt}$ wird während der Ruhephase als konstant vorausgesetzt. Dies ist bei einer thermischen Zeitkonstanten der Batterie in der Größenordnung von 10 Stunden berechtigt.

Die Extrapolation wird allerdings nur verwendet, wenn die Batterie vor der Ruhephase geladen wurde. Die Batteriespannung $U_{Batt}$ schwingt in diesem Fall von "oben" her ein. Anderenfalls werden die nach $t_{Ruhe}$=4 Stunden gemessenen Batteriespannungen direkt als Ruhespannung $U_{00}$ übernommen. Ab einer Ruhephasendauer von $t_{Ruhe}$=32 Stunden werden die Batteriespannung $U_{Batt}$ und Batterietemperatur $T_{Batt}$ im Abstand von 8 Stunden gemessen und die zu diesem Zeitpunkt gemessenen Batteriespannungen $U_{Batt}$ als Ruhespannungswerte $U_{00}$ übernommen.

Sofern im Schritt c) festgestellt wird, dass der Entlade-Batteriestrom $I_{Batt}$ > -200 mA und im Schritt d) festgestellt wird, dass der Entlade-Batteriestrom $I_{Batt}$ im Bereich von 0 bis - 50 mA liegt sowie die Ruhezeit $t_{Ruhe}$>4 Stunden ist, wird die Ruhespannung $U_{00}$ zu den Zeitpunkten $t_{Ruhe,i}$=2..5 von ungefähr 4 Stunden, 8 Stunden, 16 Stunden und 24 Stunden durch Extrapolation wie folgt ermittelt:

Verfahren 3a) - nach vorheriger Ladung der Speicherbatterie:

$$U_{Batt}(t_{Ruhe,i-1})>U_{Batt}(t_{Ruhe,i}),t_{Ruhe,i}=1..5 \approx 2 \text{ Stunden, 4 Stunden, 8 Stunden und 24 Stunden.}$$

Die Ruhespannung beträgt in diesem Fall:

$$U_{00}(t_{Ruhe,I})=U_{Batt}(t_{Ruhe,I})+\hat{u}*\ln(t_{Ruhe,i}/h)-$$

$$\hat{u}/f(T_{Batt}(t_{Ruhe,i}))*(K+E/T_{Batt}(t_{Ruhe,i})/C^\circ+273))/(1+a*\hat{u})$$

$$\hat{u}=-(U_{Batt}(t_{Ruhe,i})-U_{Batt}(t_{Ruhe,i}-1))\ln(t_{Ruhe,i}/t_{Ruhe,i-1})$$

$$f(T_{Batt})=0,0393+0,0087583*\exp(-(T_{Batt}/C^\circ+4)/16,83)$$

und den empirisch Ausmessungen bestimmten Konstanten:

E=696,0

K=-2,028

a=31,16/Volt.

Verfahren 3b) - mit vorheriger Entladung der Speicherbatterie:

$$U_{Batt}(t_{Ruhe,i-1})>U_{Batt}(t_{Ruhe,i}),t_{Ruhe,i}=1..5 \approx 2 \text{ h, 4 h, 16 h und 24 h}$$

Es gelten die für das Verfahren 3a) beschriebenen Formeln, allerdings mit den Konstanten

E=351,86

K=-1,1226

Q=-24,86.

Verfahren 3c) - mit vorherigem Laden und Entladen der Speicherbatterie:

$$U_{Batt}(t_{Ruhe,i-1})>U_{Batt}(t_{Ruhe,i}) \text{ und } U_{Batt}(t_{Ruhe,I})$$

und

$$U_{Batt}(t_{Ruhe,i-1}) \leq U_{Batt}(t_{Ruhe,i}),t_{Ruhe}=t_{Ruhe,i}=6..N \approx 32 \text{ h, 40 h und 48 h}$$

Die Ruhespannung $U_{00}$ entspricht der zu den Zeitpunkten gemessenen Batteriespannung:

$$U_{00}(t_{Ruhe,i})=U_{Batt}(t_{Ruhe,i}).$$

Für den Fall, dass im Schritt e) festgestellt wird, dass der Ruhestrom $I_{Batt}$ im Bereich von - 50 bis -200 mA liegt wird bei der Ruhespannungsermittlungsroutine gemäß Verfahren 3) mit Extrapolation zusätzlich noch die Polarisation berücksichtigt (Verfahren 4). Die Polarisationsspannung $U_{EXPOL}$ wird beispielsweise berechnet durch

$$U_{pol,ex}=(1{,}271{*}I_{Batt}+2{,}281{*}I_{Batt}^{2}+1{,}293{*}I_{Batt}^{3}){*}0{,}415{*}(1{-}0{,}0263{*}T_{Batt}[C^{\circ}]).$$

Diese Polarisationsformel unterscheidet sich von der für das Verfahren 1) beschriebenen Polarisationsformel $U_{pol,2}$ durch die Faktoren 0,415 und 0,0263.

Von den im Verfahren 3a), 3b) oder 3c) ermittelten Ruhespannungswerten $U_{00}$ wird die Polarisationsspannung $U_{pol,ex}$ subtrahiert.

Für den Fall von höheren Ruheströmen $I_{Batt}$ im betrachteten Bereich von -50 bis -200mA wird der Batteriestrom in Abhängigkeit von der Kapazität entnommen. Dies kann mit einem Kapazitätsspannungsanteil $U_{Kap}$ ausgeglichen werden:

$$U_{Kap}1{,}2/K_{0}{*}I_{Batt}{*}t_{Ruhe}.$$

Dabei ist $K_0$ die Nennkapazität der Batterie, $I_{Batt}$ der Ruhestrom und $t_{Ruhe}$ die Dauer der Ruhephase.

Für den Fall des vorherigen Entladens bestimmt sich die Ruhespannung dann wie folgt:

$$U_{Batt}(t_{Ruhe,i-1})>U_{Batt}(t_{Ruhe,i}),t_{Ruhe,i}=1..5 \approx 2\,h,\,4\,h,\,8\,h,\,16\,h\,und\,24\,h$$

$$U_{00}(t_{Ruhe,i})=U_{Batt}(t_{Ruhe,i})+\hat{u}{*}\ln(t_{Ruhe,i}/h)-$$

$$\hat{u}/f(T_{Batt}(t_{Ruhe,i})){*}(k+e/(T_{Batt}(t_{Ruhe,i})/C^{\circ}+273))/(1+a{*}\hat{u})-U_{pol,ex}-U_{Kap}$$

mit

E=696,0

K=-2,028

a=31,16/Volt.

Für den Fall des vorherigen Ladens, das heißt

$$U_{Batt}(t_{Ruhe,i-1})\leq U_{Batt}(t_{Ruhe,i}),t_{Ruhe,i}=1..5 \approx 2\,h,\,4\,h,\,8\,h,\,16\,h\,und\,24\,h$$

gelten die oben genannten Berechnungsvorschriften, allerdings mit den Konstanten

E = 351,86

K=-1,1226

Q = -24,86.

Für den Fall des vorherigen Ladens und Entladens, das heißt

$$U_{Batt}(t_{Ruhe,i-1})>U_{Batt}(t_{Ruhe,i})$$

und

$$U_{Batt}(t_{Ruhe,i-1}) \leq U_{Batt}(t_{Ruhe,i}), t_{Ruhe} = t_{Ruhe,i} = 6..N \approx 32\,h,\ 40\,h,\ 48\,h$$

berechnet sich die Ruhespannung aus der um die Polarisationsspannung $U_{pol,ex}$ und die Kapazitätsspannung $U_{KAP}$ verminderte gemessene Batterieklemmenspannung $U_{Batt}(t_{Ruhe,i})$ wie folgt:

$$U_{00}(t_{Ruhe,i}) = U_{Batt}(t_{Ruhe,i}) - U_{Pol,ex} - U_{KAP}.$$

## Patentansprüche

1. Verfahren zur Ermittlung der Ruhespannung ($U_{00}$) einer Speicherbatterie, **gekennzeichnet durch** Bestimmen von Betriebsparametern der Speicherbatterie in der Ruhephase und Bestimmen der Ruhespannung ($U_{00}$) mit jeweils einer in Abhängigkeit von den Betriebsparametern ausgewählten Ruhespannungsermittlungsroutine.

2. Verfahren nach Anspruch 1, **gekennzeichnet durch** Bestimmen der aktuellen Ruhezeit ($t_{Ruhe}$) und des Ruhestroms ($I_{Batt}$) der Batterie als Betriebsparameter.

3. Verfahren nach Anspruch 1 oder 2, **gekennzeichnet durch** Bestimmen der Ladung ($Q[k]$) der Deltakapazität ($C_{\delta}$) der Speicherbatterie als Betriebsparameter.

4. Verfahren nach Anspruch 3, **gekennzeichnet durch** Ermitteln der Ladung ($Q[k]$) der Deltakapazität ($C_{\delta}$) nach der Formel

$$Q(k) = C_{\delta} * U_{pol}(k)/3600\,(Ah/s).$$

5. Verfahren nach Anspruch 3 oder 4, **gekennzeichnet durch** Auswählen einer Ruhespannungsroutine in Abhängigkeit von der Ruhezeit ($t_{Ruhe}$), wenn die Deltakapazität ($C_{\delta}$) entladen ist ($Q[k] < 0Ah$), und in Abhängigkeit von dem Ruhestrom ($I_{Batt}$), wenn die Deltakapazität ($C_{\delta}$) nicht entladen ist ($Q[k] > 0Ah$).

6. Verfahren nach Anspruch 5, **gekennzeichnet durch** Bestimmen der Ruhespannung ($U_{00}$) mit einer die Polarisation der Speicherbatterie berücksichtigenden Ruhespannungsermittlungsroutine, wenn die aktuelle Ruhezeit ($t_{Ruhe}$) größer als 2 Stunden ist.

7. Verfahren nach Anspruch 6, **gekennzeichnet durch** Bestimmen der Ruhespannung ($U_{00}$) bei einer Ruhezeit ($t_{Ruhe}$) von 2 Stunden oder mehr nach der Beziehung

$$U_{00} = U_{Batt} - R_i * I_{Batt} - U_{pol,2}$$

mit der Batteriespannung $U_{Batt}$, dem Innenwiderstand $R_i$ der Batterie, dem Batteriestrom $I_{Batt}$ und der Polarisationsspannung $U_{pol,2}$.

8. Verfahren nach Anspruch 7, **gekennzeichnet durch** Bestimmen der Polarisationsspannung ($U_{Pol,2}$) nach der Formel

$$U_{pol,2} = (1{,}27 * I_{Batt} + 2{,}281 * I_{Batt}^{2} + 1{,}293 * I_{Batt}^{3}) * (1 - 0{,}0116 * T_{Batt}[°C])$$

mit der Batterietemperatur $T_{Batt}\,[°C]$.

9. Verfahren nach einem der vorhergehenden Ansprüche, **gekennzeichnet durch** Bestimmen der Ruhespannung ($U_{00}$) mit einer den auf die Säurekapazität ($Q_0$) bezogenen Ladezustand ($q$) berücksichtigenden Ruhespannungsermittlungsroutine, wenn die Deltakapazität ($C_{\delta}$) entladen ist und die aktuelle Ruhezeit ($t_{Ruhe}$) weniger als 2 Stunden beträgt, oder wenn die Deltakapazität ($C_{\delta}$) nicht entladen ist und der Entlade-Batteriestrom ($I_{Batt}$) zwischen -200 mA und -500 mA beträgt [-500 mA < $I_{Batt}$ < -200 mA].

**10.** Verfahren nach Anspruch 9, **gekennzeichnet durch** Bestimmen der Ruhespannung ($U_{00}$) bei einer Ruhezeit ($t_{Ruhe}$) von weniger als 2 Stunden **durch** Nachführen des Ladezustandswertes (SOC) und Berechnen der Ruhespannung ($U_{00}$) bezogen auf die Batterietemperatur ($T_{Batt}$) von 25°C aus dem nachgeführten Ladezustandswert (SOC ($Q_0$)) nach den Formeln:

$$SOC(Q_0)=SOC_0(U_{00}(T_{Batt}=25°C))+q/Q_0$$

$$SOC_0(U_{00}(T_{Batt}=25°C))=(U_{00}(T_{Batt}=25°C)-U_00,_{min}(T_{Batt}=25°C))/(U_{00},_{max}(T_{Batt}=25°C)-$$

$$U_{00},_{min}(T_{Batt}=25°C))$$

mit einer für den Speicherbatterietyp defmierten minimalen Ruhespannung $U_{00,min}$ und maximalen Ruhespannung $U_{00,max}$, dem Ladezustand q und der Säurekapazität $Q_0$.

**11.** Verfahren nach Anspruch 10, **gekennzeichnet durch** Ermitteln der Ladebilanz **durch** Interpolation des Batteriestroms ($I_{Batt}$).

**12.** Verfahren nach einem der vorhergehenden Ansprüche, **gekennzeichnet durch** Bestimmen der Ruhespannung ($U_{00}$) **durch** Extrapolation von zu verschiedenen Zeitpunkten ($t_i$) in der Ruhephase ermittelten Ruhespannungswerten ($U_{00}$, $t_i$), wenn die Deltakapazität ($C_\delta$) nicht entladen ist.

**13.** Verfahren nach Anspruch 12, **gekennzeichnet durch** Extrapolation der Ruhespannung ($U_{00}$) in Abhängigkeit von einer defmierten Polarisationsspannung ($U_{pol,ex}$), wenn die Ruhezeit ($t_{Ruhe}$) größer als 4 Stunden und der Entlade-Batteriestrom ($T_{Batt}$) zwischen -50 mA und 0 mA beträgt [-50 mA < $I_{Batt}$ < 0 mA].

**14.** Verfahren nach Anspruch 13, **gekennzeichnet durch** Subtrahieren der Polarisationsspannung ($U_{pol,ex}$) von der **durch** Extrapolation ermittelten Ruhespannung ($U_{00}$).

**15.** Verfahren nach einem der vorhergehenden Ansprüche, **gekennzeichnet durch** Ermittlung der Ruhespannung ($U_{00}$) in Abhängigkeit von der Batterietemperatur ($T_{Batt}$).

Fig. 1

**Europäisches Patentamt**

# EUROPÄISCHER RECHERCHENBERICHT

Nummer der Anmeldung

EP 05 10 3015

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X,D | DE 101 28 033 A1 (VB AUTOBATTERIE GMBH) 12. Dezember 2002 (2002-12-12) * Zusammenfassung * * Absatz [0009] - Absatz [0013] * * Absatz [0001] * * Absatz [0020] - Absatz [0029] * * Absatz [0032] * ----- | 1-4,12, 15 | G01R31/36 |
| X | US 6 163 133 A (LAIG-HORSTEBROCK ET AL) 19. Dezember 2000 (2000-12-19) * Zusammenfassung * * Spalte 2, Zeile 48 - Spalte 4, Zeile 14 * * Spalte 4, Zeile 51 - Zeile 57 * * Spalte 5, Zeile 33 - Zeile 40 * * Anspruch 5 * | 1,2 | |
| Y | | 9-11 | |
| X | US 6 646 419 B1 (YING RAMONA Y) 11. November 2003 (2003-11-11) * Zusammenfassung * * Abbildungen 3,4 * * Spalte 2, Zeile 34 - Zeile 39 * * Spalte 5, Zeile 63 - Spalte 6, Zeile 5 * * Spalte 7, Zeile 18 - Spalte 11, Zeile 60 * ----- | 1,3-5 | |
| Y | DE 102 10 516 B4 (VB AUTOBATTERIE GMBH) 26. Februar 2004 (2004-02-26) * Absatz [0035] - Absatz [0039] * ----- | 9-11 | RECHERCHIERTE SACHGEBIETE (Int.Cl.7) G01R H02J |
| A | US 5 530 362 A (BOEHM ET AL) 25. Juni 1996 (1996-06-25) * Abbildung 2 * * Spalte 4, Zeile 47 - Zeile 51 * ----- | 3-5,9,12 | |
| | -/-- | | |

Der vorliegende Recherchenbericht wurde für alle Patentansprüche erstellt

| Recherchenort | Abschlußdatum der Recherche | Prüfer |
|---|---|---|
| Berlin | 14. Juli 2005 | Höller, H |

EPO FORM 1503 03.82 (P04C03)

**EP 1 589 346 A1**

**Europäisches Patentamt**

# EUROPÄISCHER RECHERCHENBERICHT

Nummer der Anmeldung

EP 05 10 3015

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | DE 35 20 985 A1 (FORD-WERKE AG; FORD-WERKE AG, 5000 KOELN, DE) 18. Dezember 1986 (1986-12-18) * Zusammenfassung * * Ansprüche 1,4,5,9 * * Seite 7, Absatz 3 - Seite 12, Absatz 3 * ----- | 1,2,9-11 | |
| A | US 4 394 741 A (LOWNDES ET AL) 19. Juli 1983 (1983-07-19) * Spalte 1, Zeile 1 - Zeile 44 * * Spalte 36, Zeile 7 - Zeile 20 * ----- | 6-8,13, 14 | |
| A | ANONYMOUS: "Wissenswertes über Starterbatterien" INTERNET ARTICLE, [Online] 14. Februar 2004 (2004-02-14), XP002336112 Gefunden im Internet: URL:HTTP://WEB.ARCHIVE.ORG/WEB/20040214060 722/HTTP://WWW.OERLIKON-AUTOMOTIVE.CH/WISS ENSWERTES/INDEX.HTML> * Seite 20 - Seite 29 * ----- | 3,4,6,7 | RECHERCHIERTE SACHGEBIETE (Int.Cl.7) |

Der vorliegende Recherchenbericht wurde für alle Patentansprüche erstellt

| Recherchenort | Abschlußdatum der Recherche | Prüfer |
|---|---|---|
| Berlin | 14. Juli 2005 | Höller, H |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 05 10 3015

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

14-07-2005

| Im Recherchenbericht angeführtes Patentdokument | | Datum der Veröffentlichung | Mitglied(er) der Patentfamilie | | Datum der Veröffentlichung |
|---|---|---|---|---|---|
| DE 10128033 | A1 | 12-12-2002 | US | 2003001542 A1 | 02-01-2003 |
| US 6163133 | A | 19-12-2000 | DE | 19847648 A1 | 20-04-2000 |
| | | | EP | 0994362 A2 | 19-04-2000 |
| US 6646419 | B1 | 20-11-2003 | US | 2003214303 A1 | 20-11-2003 |
| | | | DE | 10320901 A1 | 04-12-2003 |
| | | | JP | 2004132949 A | 30-04-2004 |
| DE 10210516 | B4 | 02-10-2003 | DE | 10210516 A1 | 02-10-2003 |
| | | | EP | 1343017 A1 | 10-09-2003 |
| | | | US | 2004024546 A1 | 05-02-2004 |
| US 5530362 | A | 25-06-1996 | KEINE | | |
| DE 3520985 | A1 | 18-12-1986 | DE | 3682377 D1 | 12-12-1991 |
| | | | EP | 0225364 A1 | 16-06-1987 |
| | | | FR | 2583583 A1 | 19-12-1986 |
| | | | WO | 8607502 A1 | 18-12-1986 |
| | | | JP | 63500055 T | 07-01-1988 |
| US 4394741 | A | 19-07-1983 | DE | 3031852 A1 | 21-01-1982 |
| | | | DE | 3031853 A1 | 21-01-1982 |
| | | | DE | 3031887 A1 | 04-02-1982 |
| | | | DE | 3031890 A1 | 04-02-1982 |
| | | | DE | 3031898 A1 | 21-01-1982 |
| | | | DE | 3031931 A1 | 04-02-1982 |
| | | | GB | 2080550 A ,B | 03-02-1982 |
| | | | GB | 2148518 A ,B | 30-05-1985 |
| | | | GB | 2147108 A ,B | 01-05-1985 |
| | | | GB | 2147164 A ,B | 01-05-1985 |
| | | | GB | 2147160 A ,B | 01-05-1985 |
| | | | GB | 2147161 A ,B | 01-05-1985 |
| | | | US | 4433278 A | 21-02-1984 |
| | | | US | 5107191 A | 21-04-1992 |
| | | | US | 4484130 A | 20-11-1984 |

EPO FORM P0461

Für nähere Einzelheiten zu diesem Anhang : siehe Amtsblatt des Europäischen Patentamts, Nr.12/82